Europäisches Patentamt

European Patent Office

Office européen des brevets

(19)

(11) EP 0 729 587 B1

(12) EUROPÄISCHE PATENTSCHRIFT

(45) Veröffentlichungstag und Bekanntmachung des Hinweises auf die Patenterteilung:
07.01.1999 Patentblatt 1999/01

(21) Anmeldenummer: 94928289.1

(22) Anmeldetag: 07.10.1994

(51) Int Cl.⁶: $G01R\ 33/06$

(86) Internationale Anmeldenummer:
PCT/DE94/01172

(87) Internationale Veröffentlichungsnummer:
WO 95/12128 (04.05.1995 Gazette 1995/19)

(54) **VERFAHREN ZUM ABGLEICHEN EINES MAGNETORESISTIVEN SENSORS**

PROCESS FOR TUNING A MAGNETO-RESISTIVE SENSOR

PROCEDE D'AJUSTAGE D'UN DETECTEUR MAGNETORESISTIF

(84) Benannte Vertragsstaaten:
DE FR GB IT NL

(30) Priorität: 26.10.1993 DE 4336482

(43) Veröffentlichungstag der Anmeldung:
04.09.1996 Patentblatt 1996/36

(73) Patentinhaber: ROBERT BOSCH GMBH
70442 Stuttgart (DE)

(72) Erfinder:
• GALSTER, Rudolf
D-70839 Gerlingen (DE)
• GERLACH, Guenter
D-76437 Rastatt (DE)
• DUKART, Anton
D-76744 Woerth (DE)
• MARX, Klaus
D-70565 Stuttgart (DE)
• JOST, Franz
D-70565 Stuttgart (DE)

(56) Entgegenhaltungen:
DE-A- 4 221 385

• JOURNAL A, Bd.32, Nr.3, Oktober 1991, ANTWERPEN BE Seiten 43 - 50 C.J.M.EIJKEL E.A. 'Contactless angle detector for control applications'

# Beschreibung

Die Erfindung betrifft ein Verfahren zum Abgleichen eines magnetoresistiven Sensors.

## Stand der Technik

Ein gattungsgemäßes Verfahren ist zum Beispiel aus Journal A, Band 32, Nr. 3, Oktober 1991, Antwerpen, BE, Seiten 43 bis 50, C.J.M. Eikel E.A. "Contactless angle detector for control applications" bekannt. Diese Schrift offenbart ein Abgleichverfahren mit Hilfe eines homogenen, definiert ausgerichteten Magnetfeldes und mit einem definierten, über die Stromkontakte des Sensors fließenden Steuerstrom, wobei zur Kompensation einer fertigungsbedingten Offsetspannung vorgeschlagen wird, entweder einen externen Widerstand zwischen den beiden Kontakthälften eines aufgespaltenen Kontaktes vorzusehen oder alternativ den Offset mit Hilfe eines Laserstrahls auszutrimmen, wobei der von dem Laserstrahl erzeugte Schnitt in der Dünnschicht des Sensors erfolgt. Diese Maßnahme bedingt eine strukturelle Veränderung der Dünnschicht und hierdurch bedingt eine Veränderung der Sensorkennlinie, wodurch sich die Spannungsamplitude verändert und auch eine Veränderung des Offset-Temperaturganges möglich ist.

Grundsätzlich ist es bekannt, magnetoresistive Sensoren beim berührungslosen Erfassen von Zustandsänderungen einzusetzen. Dies kann zum Beispiel eine Winkelmessung an einem drehbar gelagerten Teil sein. Bei diesen magnetoresistiven Sensoren wird eine Pseudo-Hallspannung ausgenutzt, das heißt, während an zwei Stromkontakten des Sensors ein definierter Steuerstrom angelegt wird, wird durch einen über dem Sensor rotierenden Permanentmagneten der Sensor mit einem in der Ebene des Sensors liegenden Magnetfeld beaufschlagt, so daß senkrecht zur Stromrichtung eine vom Winkel der Magnetisierung zur Stromrichtung des Steuerstroms proportionale Pseudo-Hallspannung anliegt. Durch Änderung der Magnetisierungsrichtung zur Stromrichtung innerhalb des magnetoresistiven Sensors wird die Pseudo-Hallspannung beeinflußt, so daß bei konstantem Steuerstrom über das Spannungssignal auf die Stellung des das Magnetfeld hervorrufenden Magneten geschlossen werden kann.

Es ist nunmehr bekannt, diese magnetoresistiven Sensoren aus ferromagnetischen Dünnschichten herzustellen, bei denen beispielsweise eine magnetisch empfindliche Dünnschicht aus Permalloy eingesetzt wird, deren der Pseudo-Hallspannung entsprechende Ausgangssignale einer elektronischen Auswerteschaltung zugeführt werden. Die bekannten magnetoresistiven Sensoren weisen dabei eine Dünnschicht aus einer binären Legierung NiFe (Permalloy) auf, und besitzen an gegenüberliegenden Längsseiten jeweils ein Stromkontakt. An den senkrecht zu den Stromkontakten verlaufenden Seiten des magnetoresistiven Sensors sind Spannungskontakte vorgesehen, an denen die bereits erwähnte Pseudo-Hallspannung abgegriffen werden kann. Da diese Pseudo-Hallspannung dabei von der Stromstärke des angelegten Steuerstroms und dem Winkel der Magnetisierung zur Stromrichtung abhängt, kommt es auf eine genaue symmetrische Anordnung der Spannungskontakte an dem magnetoresistiven Sensor an.

Bei den bekannten Herstellungsverfahren mittels eines Maskenlayouts ist jedoch nachteilig, daß eine exakt symmetrische Anordnung der Spannungskontakte nicht erreichbar ist. Durch diese Unsymmetrie kommt es bei der abgegriffenen Pseudo-Hallspannung zu sogenannten Offsetspannungen, die eine Verfälschung des Ausgangssignals und damit eine Verfälschung des Meßergebnisses, beispielsweise der Winkelstellung eines rotierenden Teiles, bewirken. Die Offsetspannung beinhaltet dabei eine axiale Verschiebung einer die Pseudo-Hallspannung repräsentierenden Sinuskurve gegenüber der Nullachse. Je nachdem in welche Richtung die Unsymmetrie der Spannungskontakte ausgebildet ist, kommt es zu einem positiven oder negativen Offset. Zum Ausgleich dieses Offsets ist bereits vorgeschlagen worden, einen der Spannungskontakte zweipolig auszubilden und zwischen diesen einen zusätzlichen Dickschichtpotentiometer anzuordnen. Durch eine entsprechende Ausregelung des Potentiometers soll dabei der negative oder positive Offsetfehler ausgeglichen werden. Hierbei ist jedoch nachteilig, daß neben dem zusätzlichen Einbringen eines Dickschichtpotentiometers eine zusätzliche Temperaturabhängigkeit des gesamten magnetoresistiven Sensors entsteht, die wiederum durch eine aufwendige Temperaturkompensation ausgeglichen werden muß.

## Vorteile der Erfindung

Das Verfahren zum Abgleichen eines magnetoresistiven Sensors mit den im Anspruch 1 genannten Merkmalen bietet demgegenüber den Vorteil, daß einfach aufgebaute und damit kostengünstig herzustellende magnetoresistive Sensoren zur Verfügung gestellt werden können. Insbesondere dadurch, daß nunmehr kein zusätzlicher als Potentiometer ausgebildeter Dickschichtwiderstand zum Abgleich der magnetoresistiven Sensoren benötigt wird, kann einerseits die Gesamtgröße der Sensoren verringert werden, was eine weitere Miniaturisierung gesamter mit diesen Sensoren ausgestatteter Meßeinrichtungen gestattet. Andererseits wird eine geringere Temperaturabhängigkeit der Sensoren erreicht, so daß eine zusätzliche Kompensation, beispielsweise über eine temperaturabhängige Spannungsquelle, nicht notwendig ist. Dadurch, daß der magnetoresistive Sensor mit einem homogenen Magnetfeld beaufschlagt wird, an den Stromkontakten ein definierter Steuerstrom angreift und während der Messung der Pseudo-Hallspannung wenigstens einer der Spannungskontakte mit einem Laser bearbeitet wird, ist es in einfacher Weise möglich, den bearbeiteten Spannungskontakt soweit einzuschneiden, daß beim Abgreifen der Pseudo-Hallspannung an den Spannungskontakten ein elektrisches Verschieben der Kontaktanordnung bewirkt wird. Durch dieses Verschieben wird gleichzeitig ein Ausgleich des Offsets erreicht. Je nachdem, ob ein positiver oder negativer Offset vorliegt, erfolgt der Abgleich durch einen Laserschnitt in den Spannungskontakt entweder von der einen oder der anderen Seite des Spannungskontakts. Der Einschnitt in den Spannungskontakt erfolgt dabei solange, bis der Offset bei angelegtem Magnetfeld gleich Null wird.

Weitere vorteilhafte Ausgestaltungen der Erfindung ergeben sich aus den übrigen in den Unteransprüchen genannten Merkmalen.

Zeichnung

Die Erfindung wird nachfolgend in einem Ausführungsbeispiel anhand der zugehörigen Zeichnungen näher erläutert. Es zeigen:

Figur 1     eine Draufsicht auf einen magnetoresistiven Sensor;
Figur 2     einen Signalverlauf einer Pseudo-Hallspannung und
Figur 3     eine Schaltungsanordnung mit zwei magnetoresistiven Sensoren.

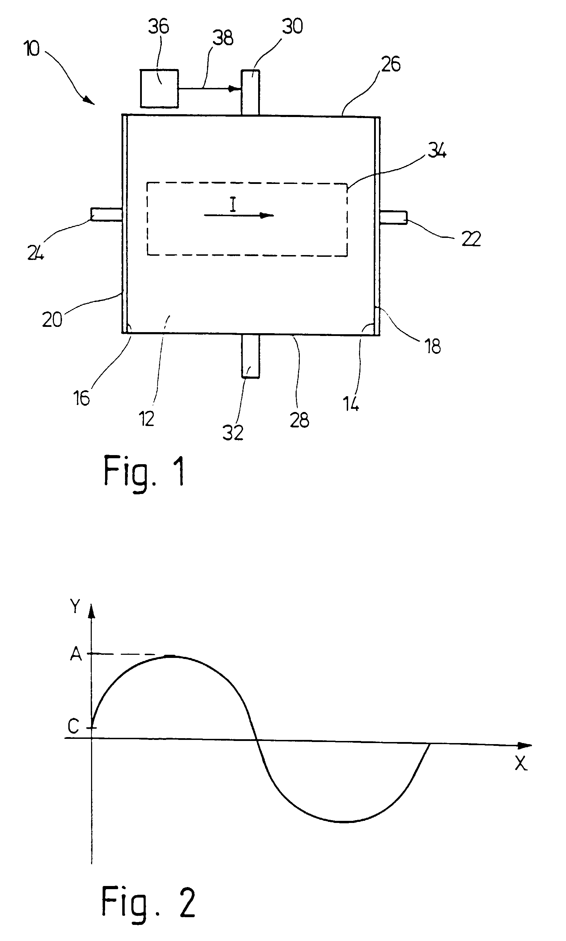

Figur 1 zeigt einen allgemein mit 10 bezeichneten magnetoresistiven Sensor. Der Sensor 10 besteht aus einer Dünnschicht 12 aus NiFe (Permalloy). An den Längsseiten 14 und 16 der Dünnschicht 12 sind Stromkontakte 18 und 20 angeordnet. Die Stromkontakte 18 und 20 besitzen Anschlußfahnen 22 und 24, die mit einer Spannungsquelle in Verbindung bringbar sind. An den rechtwinklig zu den Stromkontakten 18 bzw. 20 verlaufenden Seiten 26 und 28 der Dünnschicht 12 sind Spannungskontakte 30 und 32 angeordnet. Sowohl die Stromkontakte 18 und 20 als auch die Spannungskontakte 30 und 32 können beispielsweise aus Aluminium bestehen. Über der Dünnschicht 12 ist hier ein gestrichelt dargestellter Permanentmagnet 34 angeordnet. Der Permanentmagnet 34 ist hier nur symbolhaft dargestellt, da er tatsächlich sehr viel größer ist als der Sensor 10. Der Permanentmagnet 34 ist genau parallel zu einer durch die Anschlußfahnen 22 bzw. 24 gedachten verlaufenden Linie ausgerichtet. An den Spannungskontakt 30 greift ein von einer nur schematisch dargestellten Lasererzeugungseinrichtung 36 ausgesandter Laserstrahl 38 an.

Die in Figur 1 gezeigte Anordnung übt folgende Funktion aus:

An die Anschlußfahnen 22 und 24 wird eine eine definierte Spannung bereitstellende Spannungsquelle angeschlossen, so daß sich zwischen den Stromkontakten 18 und 20 ein genau definierter Steuerstrom I einstellt. Der Permanentmagnet 34 ist so ausgerichtet, daß ein von ihm ausgehendes magnetisches Feld genau parallel zur Stromrichtung des Steuerstromes I verläuft. Durch diese Ausrichtung des Permanentmagneten 34 ist eine Referenzmessung möglich, bei der ein Winkel zwischen dem Magnetfeld des Permanentmagneten 34 und der Stromrichtung des Steuerstromes I exakt Null Grad beträgt. Auf Grund der Tatsache, daß - wie bereits erwähnt - sich ein Zustand einstellt, der abhängig ist von der Stromstärke und der Stromrichtung des Steuerstroms sowie dem Winkel des Magnetfeldes zur Stromrichtung, entsteht an den Spannungskontakten 30 und 32 eine Potentialdifferenz. Diese Potentialdifferenz ergibt die sogenannte Pseudo-Hallspannung.

Für ein Signal der Pseudo-Hallspannung gilt folgende Beziehung:

$$V = c + A \sin 2\,\theta$$

C ist hierbei ein Wert für die Verschiebung der Sinuskurve der Pseudo-Hallspannung gegenüber der Nullachse, A ein Wert für die Amplitude der Pseudo-Hallspannung und θ der bereits erwähnte Winkel zwischen dem Magnetfeld und dem Steuerstrom I.

Es wird deutlich, daß das Ausgangssignal V der Pseudo-Hallspannung um so mehr beeinflußt wird, um so größer der Wert c des Offsets ist. Da die in Figur 1 gezeigte Meßanordnung mit einem definierten Steuerstrom I und einer definierten Flußdichte des Magnetfeldes arbeitet, kann bei einem Abgreifen der Pseudo-Hallspannung an den Spannungskontakten 30 und 32 der den Offset repräsentierende Wert c ermittelt werden. Der Offset ergibt sich insbesondere dadurch, daß bei der Herstellung des Sensors 10 mit den gängigen Maskierverfahren eine genaue symmetrische Ausrichtung der Spannungskontakte 30 und 32 nicht möglich ist, so daß der Spannungsabfall entsprechend der Kontaktversetzung als Offset wirkt. Durch diesen Offset wird eine Verschiebung des Ausgangssignals V hervorgerufen.

Indem nun während der Referenzmessung ein Spannungskontakt, hier im Beispiel der Spannungskontakt 30, mit dem Laserstrahl 38 eingeschnitten wird, erfolgt quasi ein elektrisches Verschieben des Spannungskontaktes 30. Durch dieses elektrische Verschieben des Spannungskontaktes 30 wird eine etwa vorhandene und bei der Messung der Pseudo-Hallspannung ermittelbare Abweichung, also der Offset, ausgeglichen, so daß der Einschnitt über den Laserstrahl 38 so lange erfolgen kann, bis sich ein Wert c = 0 für den Offset einstellt. Je nachdem, ob der Offset einen positiven oder negativen Wert hat, erfolgt das Einschneiden des Spannungskontaktes 30 entweder, wie im Beispiel gezeigt, von der linken oder von der rechten Seite des Spannungskontaktes 30.

Nach allem wird klar, daß sich durch dieses Abgleichverfahren eine sehr exakte Symmetrie zwischen den Spannungskontakten 30 und 32 erreichen läßt, so daß sich der Offsetfehler des gesamten Sensors 10 auf ein Minimum, beispielsweise auf einen Wert von 1 % der Amplitude des Pseudo-Hallspannungssignals, reduzieren läßt.

In der Figur 2 ist zur Verdeutlichung ein Pseudo-Hallspannungssignal gezeigt. Es wird deutlich, daß beispielsweise eine sinusförmig verlaufende Pseudo-Hallspannung durch den bereits erwähnten Offsetfehler, der durch den Wert c repräsentiert wird, entlang der x-Achse, die den Nulldurchgang repräsentiert, verschoben ist. Der Wert c nimmt dabei einen gewissen prozentualen Anteil der Amplitude A der Pseudo-Hallspannung an. Um so größer der prozentuale Anteil des Wertes c zur Amplitude A ist, um so größer ist der mit einer Auswertung der Pseudo-Hallspannung verbundene Winkel-Meßfehler.

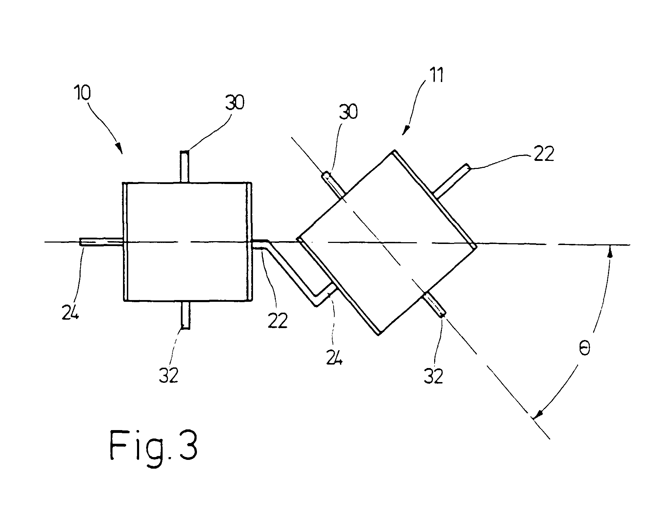

In den Figuren 1 und 2 ist das erfindungsgemäße Abgleichverfahren beispielhaft an einem Sensor 10 gezeigt. Bei einer berührungslosen Winkelmessung mit magnetoresistiven Sensoren ist es bekannt, wie in der Figur 3 gezeigt, zwei Sensoren nebeneinander anzuordnen, wobei der erste Sensor 10 um exakt 45° gegenüber einem zweiten Sensor 11 gedreht ist. Die sich gegenüberliegenden Stromkontakte der Sensoren 10 und 11 sind dabei miteinander verbunden, so daß sich eine Reihenschaltung ergibt. Durch diese zueinander gedrehte Anordnung der Sensoren 10 und 11 wird erreicht, daß bei einem von einem über den Sensoren 10 und 11 angeordneten permanenten Magneten ausgehenden Magnetfeld an beiden Sensoren 10 und 11 unterschiedliche Pseudo-Hallspannungen an den Spannungskontakten erzeugt werden. Dies ergibt sich durch den unterschiedlichen Winkel θ zwischen dem Magnetfeld und der Richtung des durch den Steuerstrom I bewirkten elektrischen Feldes. Auf weitere Einzelheiten soll hier nicht eingegangen werden, sondern es wird auf die Ausführung zu Figur 1 verwiesen.

Insgesamt ist festzuhalten, daß durch die aus den magnetoresistiven Sensoren 10 und 11 bestehende Schaltung ein Signal hervorruft, das sich aus einem Signal $V_1$ des ersten, hier links gezeichneten Sensors 10 und einem Signal $V_2$ des zweiten Sensors 11 zusammensetzt. Für $V_1$ ergibt sich die Beziehung $V_1 = c_1 + A_1 \sin 2\,\theta$, für $V_2$ die Beziehung $V_2 = c_2 + A_2 \cos 2\,\theta$. Mit c ist hier wieder ein Wert für den bereits erwähnten Offset, mit A die jeweilige Amplitude der Pseudo-Hallspannung und mit θ der Magnetisierungswinkel bezeichnet. θ beträgt hierbei für den ersten Sensor 10 0° und für den zweiten Sensor 11 45°.

Damit nun der von dieser Schaltung ausgehende Offsetfehler reduziert werden kann, wird ein Abgleich für den ersten Sensor 10 durchgeführt, wie er bereits zu der Figur 1 erläutert wurde. Ein analoger Abgleich des zweiten Sensors 11 wird derart durchgeführt, daß der Permanentmagnet 34 exakt um 45° gedreht wird, so daß sich ein Winkel θ für den in Figur 3 gezeigten zweiten Sensor 11 von 0° einstellt. Nunmehr kann mittels der bereits erwähnten Lasereinschnittstechnik eine exakt symmetrische Ausrichtung der Spannungskontakte 30 und 32 für den zweiten Sensor 11 erfolgen. Insgesamt gesehen kann durch das beschriebene Abgleichverfahren für die in Figur 3 gezeigte Schaltung zweier magnetoresistiver Sensoren 10 und 11 eine sehr hohe Genauigkeit des Ausgangssignals und damit eines Meßergebnisses erreicht werden. Weiterhin können diese Sensoren auf einer sehr kleinen Fläche untergebracht werden, so daß eine Anordnung von Magnetfühlern, die beispielsweise die Winkelstellung eines rotierenden Teiles messen sollen, in sehr kleinen Bauteilen möglich ist.

Es kann auch vorgesehen sein, daß der Abgleich der an den Sensoren 10 und 11 bestehenden Schaltung oder auch nur eines Sensors 10 dynamisch erfolgt. Das heißt, der Permanentmagnet 34 befindet sich in Rotation und während mehrerer Umdrehungen wird zur exakt festgelegten Winkelposition, vorzugsweise zu den genannten Winkelpositionen, der Wert c für den Offset rechnerich ermittelt. Im Anschluß nach einer wählbaren Meßperiode kann dann der Einschnitt der Spannungskontakte 30 und/oder 32 erfolgen. Durch diesen dynamischen Abgleich läßt sich ein eventueller Meßfehler während des Trimmens der magnetoresistiven Sensoren verringern bzw. kompensieren.

**Patentansprüche**

1. Verfahren zum Abgleichen eines magnetoresistiven Sensors, der mit einem homogenen, definiert ausgerichteten Magnetfeld beaufschlagt und an dessen Stromkontakte (22, 24) ein definierter Steuerstrom (I) angelegt wird, dadurch gekennzeichnet, daß während der Messung einer Pseudo-Hallspannung wenigstens einer der Spannungskontakte (30, 32) beispielsweise mit einem Laserstrahl (38) eingeschnitten wird.

2. Verfahren nach Anspruch 1, dadurch gekennzeichnet, daß während der Messung der Pseudo-Hallspannung ein einen Offset repräsentierender Wert ( c) ermittelt wird.

3. Verfahren nach Anspruch 2, dadurch gekennzeichnet, daß in Abhängigkeit eines positiven oder negativen Wertes (c ) des Offset der Abgleich durch einen Laserschnitt in den Spannungskontakt (30 oder 32) entweder von der einen oder anderen Seite des Spannungskontaktes (30, 32) erfolgt.

4. Verfahren nach einem der vorhergehenden Ansprüche, dadurch gekennzeichnet, daß beim Abgleich einer aus zwei magnetoresitiven Sensoren (10, 11) bestehenden Schaltung diese nacheinander abgeglichen werden.

5. Verfahren nach Anspruch 4, dadurch gekennzeichnet, daß beim Abgleich eines ersten magnetoresistiven Sensors (10) ein von einem Permanentmagneten (34) ausgehender Magnetisierungswinkel von 0° zum Sensor (10) eingestellt wird.

6. Verfahren nach Anspruch 4, dadurch gekennzeichnet, daß beim Abgleich eines zweiten magnetoresistiven Sensors (11) ein Magnetisierungswinkel von 0° zum zweiten Sensor (11) bzw. von 45° zum ersten Sensor (10) eingestellt wird.

7. Verfahren nach Anspruch 4, dadurch gekennzeichnet, daß der Abgleich dynamisch erfolgt und nach mehreren Umdrehungen des Permanentmagneten (34) der den Offset repräsentierende Wert (c ) rechnerisch ermittelt wird und das Einschneiden der Spannungskontakte (30, 32) anschließend erfolgt.

8. Verfahren nach einem der vorhergehenden Ansprüche, dadurch gekennzeichnet, daß das Einschneiden des Spannungskontaktes (30, 32) so lange erfolgt, bis der den Offset repräsentierende Wert (c ) einen Betrag von 0 annimmt.

## Claims

1. Method for calibrating a magnetoresistive sensor to which a homogeneous magnetic field of defined alignment is applied and to whose current contacts (22, 24) a defined control current (I) is applied, characterized in that during the measurement of a pseudo-Hall voltage at least one of the voltage contacts (30, 32) is incised, for example by means of a laser beam (38).

2. Method according to Claim 1, characterized in that during the measurement of the pseudo-Hall voltage a value (c) representing an offset is determined.

3. Method according to Claim 2, characterized in that the calibration is performed by means of a laser incision into the voltage contact (30 or 32) either from the one or the other side of the voltage contact (30, 32) as a function of a positive or negative value (c) of the offset.

4. Method according to one of the preceding claims, characterized in that in the case of calibrating a circuit consisting of two magnetoresistive sensors (10, 11), the latter are calibrated one after another.

5. Method according to Claim 4, characterized in that in the case of calibrating a first magnetoresistive sensor (10), a magnetization angle of 0° originating from a permanent magnet (34) is set relative to the sensor (10).

6. Method according to Claim 4, characterized in that in the case of calibrating a second magnetoresistive sensor (11), a magnetization angle of 0° is set relative to the second sensor (11) or a magnetization angle of 45° is set relative to the first sensor (10).

7. Method according to Claim 4, characterized in that the calibration is performed dynamically, and the value (c) representing the offset is determined by computer after a plurality of revolutions of the permanent magnet (34) and the incision of the voltage contacts (30, 32) is performed subsequently.

8. Method according to one of the preceding claims, characterized in that the incision of the voltage contact (30, 32) is performed until the value (c) representing the offset assumes a magnitude of 0.

## Revendications

1. Procédé servant à ajuster un détecteur magnétorésistif, qui est sollicité par un champ magnétique homogène, orienté de façon définie et sur les contacts d'intensité (22, 24) duquel on applique une intensité définie de commande (I),
caractérisé en ce que
pendant la mesure d'une pseudo tension de Hall on entaille par exemple avec un rayon laser (38) au moins l'un des contacts de tension (30, 32)

2. Procédé selon la revendication 1,
caractérisé en ce que
pendant la mesure de la pseudo tension de Hall on détermine une valeur (c) représentant un offset.

3. Procédé selon la revendication 2,
caractérisé en ce que
l'ajustage a lieu par une entaille effectuée par un rayon laser dans le contact de tension (30 ou 32) de l'un ou l'autre côté du contact de tension (30, 32), en fonction d'une valeur (c) positive ou négative de l'offset.

4. Procédé selon l'une des revendications précédentes, caractérisé en ce que
lors de l'ajustage d'un circuit se composant de deux détecteurs magnétorésistifs on ajuste ceux-ci l'un après l'autre

5. Procédé selon la revendication 4,
caractérisé en ce que
lors de l'ajustage d'un premier détecteur magnétorésistif (10) on établit un angle de magnétisation de 0°, partant d'un aimant permanent (34) par rapport au détecteur (10)

6. Procédé selon la revendication 4,
caractérisé en ce que

lors de l'ajustage d'un deuxième détecteur magnétorésistif (11), on établit un angle de magnétisation de 0° par rapport au deuxième détecteur (11) ou de 45° par rapport au premier détecteur (10).

7. Procédé selon la revendication 4, caractérisé en ce que

- l'ajustage a lieu de façon dynamique et la valeur (c), qui représente l'offset, est déterminée par le calcul après plusieurs révolutions de l'aimant permanent (34) et
- l'entaille des contacts de tension (30, 32) a lieu ensuite.

8. Procédé selon l'une des revendications précédentes, caractérisé en ce que l'entaille du contact de tension (30, 32) a lieu jusqu'à ce que la valeur (c) qui représente l'offset prend une valeur d'un montant égal à zéro.

Fig. 1

Fig. 2

Fig.3